# DEMANDE DE BREVET EUROPEEN

(11) **EP 3 379 141 A1**
(43) Date de publication de la demande: **26.09.2018**
(21) Numéro de dépôt: 18161319.1
(22) Date de dépôt: 12.03.2018
(51) Int. Cl.: F21S 41/141

(54) **SOURCE DE LUMIERE MONOLITHIQUE POUR UN MODULE LUMINEUX DE VEHICULE AUTOMOBILE**

(30) Priorité: 24.03.2017 FR 1752499
(71) Demandeur: Valeo Vision, 93012 Bobigny Cedex (FR)
(72) Inventeur: PELLARIN, Marie, 93012 Bobigny Cedex (FR); SANCHEZ, Vanesa, 93012 Bobigny Cedex (FR); DELANDE, Benoit, 93012 Bobigny Cedex (FR)
(74) Mandataire: Valeo Vision

(57) **Abrégé**

Une source de lumière monolithique (1) pour un module lumineux de véhicule automobile comprend une surface d'émission (30) formée par une pluralité d'éléments émissifs (8) et configurée de sorte que les éléments émissifs sont agencés en au moins trois portions activables sélectivement parmi lesquelles une première (31) et une deuxième (32) portions qui sont symétriques l'une de l'autre par rapport à un plan de symétrie (P1), avec une zone de contact (35) qui s'étend le long de ce plan de symétrie, et une troisième portion (33) qui s'étend depuis une extrémité de cette zone de contact et qui s'étend symétriquement de part et d'autre du plan de symétrie.

## Description

L'invention a trait au domaine de l'éclairage et/ou de la signalisation, notamment pour véhicules automobiles.

Un véhicule automobile est équipé de projecteurs, ou phares, destinés à illuminer la route devant le véhicule, la nuit ou en cas de luminosité réduite. Ces projecteurs peuvent généralement être utilisés selon deux modes d'éclairage : un premier mode « feux de route » et un deuxième mode « feux de croisement ». Le mode « feux de route » permet d'éclairer fortement la route loin devant le véhicule. Le mode « feux de croisement » procure un éclairage plus limité de la route, mais offrant néanmoins une bonne visibilité, sans éblouir les autres usagers de la route. Ces deux modes d'éclairage sont utilisés alternativement en fonction des conditions de circulation rencontrées par le véhicule, et ils sont successivement mis en oeuvre par une commande manuelle du véhicule ou bien automatiquement par un dispositif de commande approprié.

Par ailleurs, les modules présents dans les projecteurs sont agencés pour que les faisceaux relatifs au mode « feux de croisement » présentent un découpage dans leur partie supérieure formant une marche, pour éviter d'être trop pénalisant pour la conduite des véhicules venant en sens inverse. On comprend que le faisceau à obtenir dans le cas d'une circulation à droite de la route présente un découpage sur la gauche du faisceau, tandis que de façon symétrique le faisceau à obtenir dans le cas d'une circulation à gauche de la route présente un découpage sur la droite du faisceau.

Il est recherché l'obtention de modules lumineux susceptibles de générer aussi bien un faisceau relatif au mode « feux de route » qu'au mode « feux de croisement », par un pilotage approprié d'une source de lumière spécifique, avec notamment la formation d'une découpe en forme de marche, telle qu'elle vient d'être évoquée. Le document US2009180294 divulgue la mise en oeuvre d'une telle source de lumière, présentant des zones d'émission particulières en ce que leur activation simultanée ou sélective permet de créer une surface d'émission propre à un faisceau de type « feux de route » ou à un faisceau de type « feux de croisement ».

On comprend que l'ensemble des surfaces d'émission est activé pour générer un faisceau de type « feux de route » et que seule une partie des surfaces d'émission est activée pour générer un faisceau de type « feux de croisement ».

On s'affranchit de la sorte de la présence dans le module lumineux, entre d'une part une source de lumière et un collecteur vers lequel la source de lumière est apte à émettre des rayons lumineux et qui est configuré pour dévier ces rayons et d'autre part une optique de mise en forme des rayons déviés pour générer un faisceau dirigé en sortie du module, d'un cache disposé sur le trajet des rayons pour couper une partie des rayons et donner une forme adéquate au faisceau.

Si une telle configuration est avantageuse en ce qu'elle implique une pièce en moins dans le module, elle oblige à prévoir des modules différents, avec notamment un premier ou un deuxième type de source de lumière, pour les véhicules prévus pour circuler à droite de la route ou pour circuler à gauche de la route. On comprend que les coûts de conception et de fabrication sont impactés par cette alternative à prendre en compte.

La présente invention vise à proposer une source de lumière et un module lumineux associé qui apportent une solution de standardisation des composants selon que l'on souhaite équiper un véhicule pour une conduite à gauche ou un véhicule pour une conduite à droite. Dans ce qui suit, on entend par véhicule pour conduite à gauche, respectivement à droite, un véhicule amené à circuler sur des voies à gauche, respectivement sur des voies à droite, de la chaussée.

A cet effet, l'invention vise à proposer une source de lumière monolithique pour un module lumineux de véhicule automobile comprenant une surface d'émission formée par une pluralité d'éléments émissifs activables sélectivement et configurée de sorte que les éléments émissifs sont agencés en au moins trois portions activables sélectivement parmi lesquelles une première et une deuxième portions qui sont symétriques l'une de l'autre par rapport à un plan de symétrie, avec une zone de contact qui s'étend le long de ce plan de symétrie, et une troisième portion qui s'étend depuis une extrémité de cette zone de contact et qui s'étend symétriquement de part et d'autre du plan de symétrie.

On entend par source de lumière monolithique une source de lumière dans laquelle les éléments émissifs sont des éléments électroluminescents dont la croissance s'est effectuée depuis un substrat commun et qui sont connectés électriquement de manière à être activables sélectivement, individuellement ou par sous-ensemble d'éléments émissifs, la configuration d'une telle source monolithique permettant l'agencement de pixels activables sélectivement très proches les uns des autres, par rapport aux diodes électroluminescentes classiques destinées à être soudés sur des plaques de circuits imprimés. La source monolithique au sens de l'invention comporte des éléments électroluminescents dont une dimension principale d'allongement, à savoir la hauteur, est sensiblement perpendiculaire à un substrat commun, cette hauteur étant au moins égale au micromètre.

Selon différentes caractéristiques de la présente invention, prises seules ou en combinaison, on pourra prévoir que :
- la troisième portion présente une forme de bande dont l'épaisseur à une extrémité diminue progressivement pour former une pointe dont le sommet est confondu avec le point d'intersection des première, deuxième et troisième portions activables sélectivement ;
- la pointe participant à délimiter la troisième portion forme dans la surface d'émission un angle avec le plan de symétrie qui est compris entre 15° et 90°, notamment compris entre 15° et 45°, et notamment égal à 35° +/- 5° ;
- la surface d'émission est rectangulaire ;
- la surface d'émission est carrée, et elle présente un côté de longueur comprise entre 2 et 4 mm, et notamment égale à 2,62mm ;
- chacune des portions d'émission débouche sur un bord de la surface d'émission rectangulaire ;
- chacune des première et deuxième portions comporte un sous-ensemble agencé le long de la troisième portion et au moins partiellement le long de la zone de contact entre ces deux portions, depuis le point d'intersection ;
- chaque sous-ensemble s'étend sur tout le long de la zone de contact entre la première et la deuxième portion ;
- la largeur de chaque sous-ensemble est constante d'un bord à l'autre de la surface d'émission de la source ; par largeur, on entend la dimension de la bande perpendiculairement à la zone de contact et/ou perpendiculaire à la jonction entre la troisième portion et la première portion ;
- les éléments émissifs contenus dans un sous-ensemble sont configurés pour émettre des rayons d'intensité lumineuse supérieure à celle des rayons émis par les éléments émissifs contenus dans le reste de la première ou deuxième portion que comporte ledit sous-ensemble ;
- la densité et/ou la hauteur des éléments émissifs est différente selon que l'on soit dans le sous-ensemble ou dans le reste de la portion correspondante, ou bien les éléments émissifs agencés dans le sous-ensemble sont suralimentés par rapport au reste des éléments émissifs de la portion correspondante ;
- la source de lumière monolithique comporte deux portions additionnelles disposées symétriquement par rapport au plan de symétrie, en entourant les première, deuxième et troisième portions ;
- la source de lumière monolithique comporte des moyens de détrompage de son installation dans le module lumineux ; ces moyens de détrompage peuvent consister en un repère de forme ou de couleur spécifique ménagé en bordure de la surface d'émission, ce repère étant identifiable par un dispositif de contrôle lors de la mise en place de la source de lumière monolithique dans le module lumineux.

L'invention concerne également un module lumineux comportant une source de lumière monolithique telle qu'elle vient d'être décrite et une optique de mise en forme. La source de lumière monolithique et l'optique de mise en forme peuvent être configurées de sorte que les rayons émis par la source de lumière monolithique impactent directement l'optique de mise en forme, sans déviation intermédiaire. Et l'optique de mise en forme peut être configurée pour déformer l'image selon au moins un axe, et notamment selon un axe compris dans la surface d'émission et perpendiculaire au plan de symétrie, afin de modifier la pente définie par la pointe de la troisième portion.

Dans le module lumineux selon l'invention, la surface d'émission de la source de lumière monolithique peut être carrée, avec un côté de longueur sensiblement égale à 2,62mm et la source de lumière monolithique peut être disposée sur le foyer de l'optique de mise en forme, à 30mm de celle-ci.

L'invention concerne également un projecteur de véhicule automobile comportant un module lumineux tel que précédemment décrit. Ce projecteur peut comporter un module complémentaire configuré pour former un faisceau complémentaire au faisceau formé en sortie du module lumineux.

L'invention concerne en outre un procédé d'éclairage d'un véhicule automobile mettant en oeuvre le pilotage d'une source de lumière monolithique telle que précédemment décrite, pour réaliser une première fonction d'éclairage non éblouissante, par projection d'un faisceau à coupure, ou une deuxième fonction d'éclairage à longue portée, par projection d'un deuxième faisceau sans coupure. Au cours de ce procédé, on peut détecter l'orientation de la source de lumière monolithique, par une mesure directe ou bien par récupération d'informations relatives à cette orientation, et on peut activer chacune des trois portions de la source de lumière monolithique pour réaliser la deuxième fonction d'éclairage à longue portée, et uniquement l'une parmi la première et la deuxième portion pour réaliser la première fonction d'éclairage non éblouissante, le choix de l'activation de la première ou de la deuxième portion étant fonction de la détection de l'orientation de la source de lumière monolithique.

Selon une caractéristique, les trois portions peuvent être activées pour la réalisation de la deuxième fonction d'éclairage de manière à produire le maximum d'intensité lumineuse permis par leurs dimensions et leur structure.

Selon une autre caractéristique, l'une parmi la première ou la deuxième portion peut être activée pour la réalisation de la première fonction d'éclairage de manière à produire une intensité lumineuse comprise entre 30 et 50% du maximum d'intensité lumineuse permis par leurs dimensions et leur structure.

Par ailleurs, le sous-ensemble de l'une parmi la première ou la deuxième portion peut être activé pour la réalisation de la première fonction d'éclairage de manière à produire une intensité lumineuse sensiblement égale à 50% du maximum d'intensité lumineuse permis par la dimension et la structure des éléments émissifs le composant, tandis que le reste de la première ou de la deuxième portion correspondante est activé pour la réalisation de la première fonction d'éclairage de manière à produire une intensité lumineuse sensiblement égale à 30% du maximum d'intensité lumineuse permis par la dimension et la structure des éléments émissifs la composant, les éléments émissifs étant identique entre le sous-ensemble et le reste de la première ou deuxième portion.

Les caractéristiques de l'invention mentionnées ci-dessus, ainsi que d'autres, apparaîtront plus clairement à la lecture ci-dessous de la description détaillée d'exemples non limitatifs, en se référant aux dessins annexés parmi lesquels :

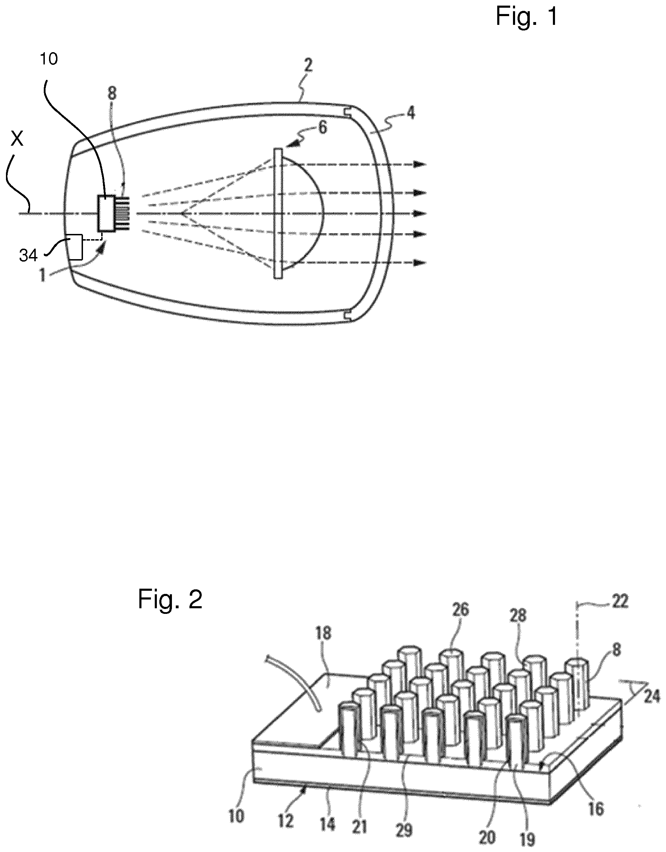

- la figure 1 est une représentation schématique d'un boîtier d'un dispositif d'éclairage adaptatif dans lequel sont logés une source de lumière monolithique et une optique de mise en forme des rayons émis, figure dans laquelle on a illustré des rayons lumineux émis par la source de lumière monolithique et déviés par l'optique de mise en forme ;
- la figure 2 est une représentation schématique en perspective de la source de lumière monolithique de la figure 1, dans laquelle on a rendu visible en coupe une rangée de bâtonnets électroluminescents ;

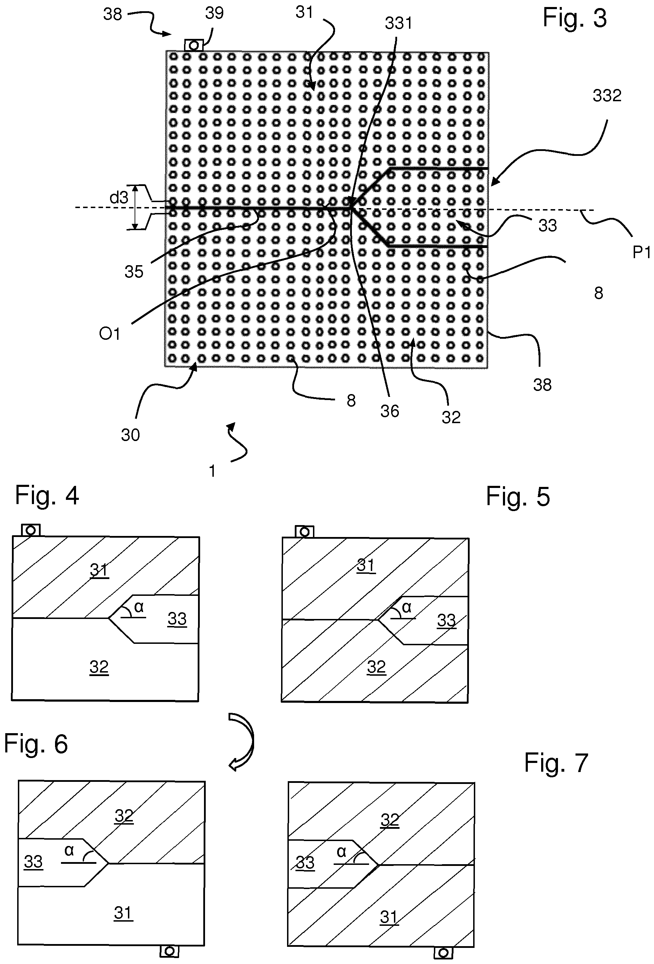

- la figure 3 est une illustration de la surface d'émission d'éclairage formée par les éléments émissifs d'une source de lumière monolithique du type de celle illustrée sur la figure 2, dans laquelle est rendu visible un découpage de la surface d'émission en trois portions activables sélectivement comportant chacune une pluralité d'éléments émissifs ;

- les figures 4 à 7 sont des exemples d'activation de la source de lumière monolithique illustrant le pilotage des portions d'éléments émissifs activables sélectivement en fonction d'un souhait de générer un faisceau de type « feux de croisement » (figure 4) ou de type « feux de route » (figure 5) pour une source de lumière monolithique installée dans une première position pour un véhicule destiné à la conduite à gauche de la route, et illustrant le pilotage des portions d'éléments émissifs activables sélectivement en fonction d'un souhait de générer un faisceau de type « feux de croisement » (figure 6) ou de type « feux de route » (figure 7) pour une source de lumière monolithique installée dans une deuxième position pour un véhicule destiné à la conduite à droite de la route ;

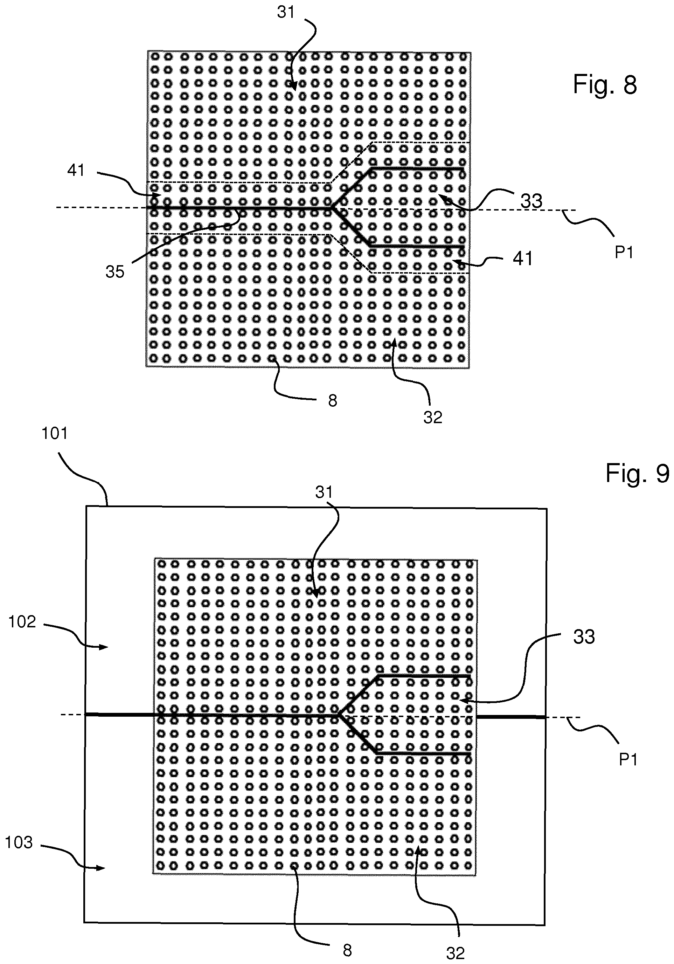

- la figure 8 est une illustration, similaire à celle de la figure 3, d'une source de lumière monolithique du type de celle illustrée sur la figure 2, selon une première variante de réalisation dans laquelle deux des trois portions présentent chacune un sous-ensemble d'éléments émissifs ;
- et la figure 9 est une illustration, similaire à celle des figures 3 et 4, d'une source de lumière monolithique du type de celle illustrée sur la figure 2, selon une deuxième variante de réalisation dans laquelle la surface d'émission correspondant aux trois portions est entourée par deux portions additionnelles symétriques.

Un module lumineux configuré pour équiper un projecteur d'un véhicule automobile, tel qu'il fait l'objet d'un aspect de l'invention, comporte une source de lumière monolithique 1, notamment logée dans un boîtier 2 fermé par une glace 4 et qui définit un volume interne de réception de ce module lumineux. La source de lumière monolithique est associée à une optique de mise en forme 6 d'au moins une partie des rayons lumineux émis par la source de lumière, l'optique de mise en forme étant également logé dans le boîtier et comportant au moins une lentille, et par exemple une lentille convergente. L'optique de mise en forme change une direction d'au moins une partie des rayons lumineux émis par la source pour l'émission d'un faisceau lumineux adaptatif en dehors du module, et sensiblement parallèlement à un axe optique du module X illustré sur la figure 1. L'optique de mise en forme est ainsi configurée pour déformer l'image selon au moins un axe.

Le module lumineux fonctionne ici en imagerie directe, avec la source de lumière monolithique et l'optique de mise en forme qui sont configurées de sorte que les rayons émis par la source de lumière impactent directement l'optique de mise en forme, sans déviation intermédiaire.

La source de lumière monolithique 1 présente une surface d'émission d'éclairage 30 définie par une pluralité d'éléments émissifs 8 répartis de manière à former trois portions adressables, et plus particulièrement activables, sélectivement par instruction d'un module de commande associée à la source de lumière, et le module peut générer la réalisation d'un faisceau « feux de route » et d'un faisceau « feux de croisement », par allumage sélectif des éléments émissifs d'une portion plutôt que ceux d'une autre portion. On saura décrire dans ce qui suit comment est réalisé ce pilotage.

La configuration de la source de lumière monolithique, à savoir notamment l'agencement des éléments émissifs 8 en portions activables sélectivement, est fonction du type de faisceau « feux de croisement » que l'on souhaite, et notamment fonction de la pente et de la hauteur de la marche formant découpe du faisceau.

Selon l'invention, la source de lumière est monolithique en ce qu'une pluralité d'éléments émissifs 8 s'étendent en saillie d'un substrat commun à partir duquel ils ont crû respectivement. Différents agencements d'éléments émissifs peuvent répondre à cette définition de source monolithique, dès lors que les éléments émissifs présentent l'une de leurs dimensions principales d'allongement sensiblement perpendiculaire à un substrat commun et que l'écartement entre les pixels, formés par un ou plusieurs éléments émissifs regroupés ensemble, est faible en comparaison des écartements imposés dans des agencements connus de chips carrés plates soudés sur une carte de circuits imprimés.

Notamment la source de lumière monolithique selon un aspect de l'invention peut comporter, tel que cela va être décrit plus en détails ci-après, une pluralité d'éléments émissifs électroluminescents distincts des autres et que l'on fait croitre individuellement depuis le substrat, en étant connectés électriquement pour être activables sélectivement, le cas échéant par sous-ensembles au sein desquels des bâtonnets peuvent être activés simultanément.

En variante, la source de lumière peut comporter des éléments émissifs formés par des couches d'éléments électroluminescents que l'on superpose sur un substrat unique et que l'on découpe pour former une pluralité de pixels respectivement issus d'un même substrat. Il résulte d'une telle conception une pluralité de blocs émissifs tous issus d'un même substrat et connectés électriquement pour être activables sélectivement les uns des autres.

On comprend que dans chacun des cas de mise en oeuvre d'une source monolithique selon l'invention, on peut ainsi, par le raccordement électrique des éléments émissifs distincts des autres ou bien par la forme des découpages des blocs émissifs, réaliser des agencements particuliers des portions activables sélectivement dans la surface d'émission d'éclairage, que ce soit au niveau de leurs formes ou de leurs dimensions.

Tel qu'illustré sur la figure 2, la source de lumière 1 comprend de la sorte une pluralité d'éléments électroluminescents 8, de dimensions submillimétriques, qui sont agencés en saillie d'un substrat 10 de manière à former ici des bâtonnets de section hexagonale. Les bâtonnets électroluminescents 8 s'étendent parallèlement à l'axe optique X du module lumineux quand la source de lumière 1 et l'optique de mise en forme 6 sont en position dans le boîtier 2.

Ces bâtonnets électroluminescents 8 sont regroupés, notamment par des connexions électriques propres à chaque ensemble, en une pluralité de portions activables sélectivement. On décrira ci-après l'agencement de ces portions, dont le dessin spécifique est prévu pour permettre de réaliser simplement le passage d'un faisceau de type « feux de route » ou d'un faisceau de type « feux de croisement », et ce aussi bien pour un véhicule de type conduite à gauche que pour un véhicule de type conduite à droite.

Les bâtonnets électroluminescents 8 prennent naissance sur une première face d'un substrat 10. Chaque bâtonnet électroluminescent, ici formé par utilisation de nitrure de gallium (GaN), s'étend perpendiculairement, ou sensiblement perpendiculairement, en saillie du substrat, ici réalisé à base de silicium, d'autres matériaux comme du carbure de silicium pouvant être utilisés sans sortir du contexte de l'invention. A titre d'exemple, les bâtonnets électroluminescents pourraient être réalisés à partir d'un alliage de nitrure d'aluminium et de nitrure de gallium (AlGaN), ou à partir d'un alliage de phosphures d'aluminium, d'indium et de gallium (AllnGaP).

Le substrat 10 présente une face inférieure 12, sur laquelle est rapportée une première électrode 14, et une face supérieure 16, en saillie de laquelle s'étendent les bâtonnets électroluminescents 8, jouant le rôle de la première face du substrat précédemment évoquée, et sur laquelle est rapportée une deuxième électrode 18. Différentes couches de matériaux sont superposées sur la face supérieure 16, notamment après la croissance des bâtonnets électroluminescents depuis le substrat ici obtenue par une approche ascendante. Parmi ces différentes couches, on peut trouver au moins une couche de matériau conducteur électriquement, afin de permettre l'alimentation électrique des bâtonnets. Cette couche est gravée de manière à relier tel ou tel bâtonnet entre eux, l'allumage de ces bâtonnets électroluminescents pouvant alors être commandé simultanément par un module de commande ici non représenté. On pourra prévoir qu'au moins deux bâtonnets électroluminescents ou au moins deux groupes de bâtonnets électroluminescents sont agencés pour être allumés de manière distincte par l'intermédiaire d'un système de contrôle de l'allumage.

Les bâtonnets électroluminescents s'étirent depuis le substrat et, tel que cela est visible sur la figure 2, ils comportent chacun un noyau 19 en nitrure de gallium, autour duquel sont disposés des puits quantiques 20 formés par une superposition radiale de couches de matériaux différents, ici du nitrure de gallium et du nitrure de gallium-indium, et une coque 21 entourant les puits quantiques également réalisé en nitrure de gallium.

Chaque bâtonnet électroluminescent s'étend selon un axe d'allongement 22 définissant sa hauteur, la base de chaque bâtonnet étant disposée dans un plan 24 de la face supérieure 16 du substrat 10.

Les bâtonnets électroluminescents 8 d'une même source de lumière présentent avantageusement la même forme. Ils sont chacun délimités par une face terminale 26 et par une paroi circonférentielle 28 qui s'étend le long de l'axe d'allongement du bâtonnet. Lorsque les bâtonnets électroluminescents sont dopés et font l'objet d'une polarisation, la lumière résultante en sortie de la source à semi-conducteurs est émise essentiellement à partir de la paroi circonférentielle 28, étant entendu que des rayons lumineux peuvent sortir également de la face terminale 26. Il en résulte que chaque bâtonnet électroluminescent agit comme une unique diode électroluminescente et que la luminance de cette source est améliorée d'une part par la densité des bâtonnets électroluminescents 8 présents et d'autre part par la taille de la surface éclairante définie par la paroi circonférentielle et qui s'étend donc sur tout le pourtour, et toute la hauteur, du bâtonnet.

La paroi circonférentielle 28 d'un bâtonnet électroluminescent 8, correspondant à la coquille de nitrure de gallium, est recouverte par une couche d'oxyde conducteur transparent (OCT) 29 qui forme l'anode de chaque bâtonnet complémentaire à la cathode formée par le substrat. Cette paroi circonférentielle 28 s'étend le long de l'axe d'allongement 22 depuis le substrat 10 jusqu'à la face terminale 26, la distance de la face terminale 26 à la face supérieure 16 du substrat, depuis laquelle prennent naissance les bâtonnets électroluminescents 8, définissant la hauteur de chaque bâtonnet. A titre d'exemple, on prévoit que la hauteur d'un bâtonnet électroluminescent 8 est comprise entre 1 et 10 micromètres, tandis que l'on prévoit que la plus grande dimension transversale de la face terminale, perpendiculairement à l'axe d'allongement 22 du bâtonnet concerné, soit inférieure à 2 micromètres. On pourra également prévoir de définir la surface d'un bâtonnet, dans un plan de coupe perpendiculaire à cet axe d'allongement 22, dans une plage de valeurs déterminées, et notamment entre 1.96 et 4 micromètres carré.

On comprend que, lors de la formation des bâtonnets électroluminescents 8, la hauteur peut être modifiée d'une zone de la source de lumière à l'autre, de manière à accroitre la luminance de la zone correspondante lorsque la hauteur moyenne des bâtonnets la constituant est augmentée. Ainsi, un groupe de bâtonnets électroluminescents peut avoir une hauteur, ou des hauteurs, différentes d'un autre groupe de bâtonnets électroluminescents, ces deux groupes étant constitutifs de la même source de lumière à semi-conducteur comprenant des bâtonnets électroluminescents de dimensions submillimétriques.

La forme des bâtonnets électroluminescents 8 peut également varier d'un dispositif à l'autre, notamment sur la section des bâtonnets et sur la forme de la face terminale 26. Les bâtonnets présentent une forme générale cylindrique, et ils peuvent notamment présenter une forme de section polygonale, et plus particulièrement hexagonale. On comprend qu'il importe que de la lumière puisse être émise à travers la paroi circonférentielle, que celle-ci présente une forme polygonale ou circulaire.

Par ailleurs, la face terminale 26 peut présenter une forme sensiblement plane et perpendiculaire à la paroi circonférentielle, de sorte qu'elle s'étend sensiblement parallèlement à la face supérieure 16 du substrat 10, ou bien elle peut présenter une forme bombée ou en pointe en son centre, de manière à multiplier les directions d'émission de la lumière sortant de cette face terminale.

Dans une variante non représentée, la source de lumière 1 à semi-conducteur peut comporter en outre une couche d'un matériau polymère dans laquelle les bâtonnets électroluminescents sont au moins partiellement noyées. La couche peut ainsi s'étendre sur toute l'étendue du substrat ou seulement autour d'un groupe déterminé de bâtonnets électroluminescents. Le matériau polymère, qui peut notamment être à base de silicone, crée une couche protectrice qui permet de protéger les bâtonnets électroluminescents sans gêner la diffusion des rayons lumineux. En outre, il est possible d'intégrer dans cette couche de matériau polymère des moyens de conversion de longueur d'onde, et par exemple des luminophores, aptes à absorber au moins une partie des rayons émis par l'un des bâtonnets et à convertir au moins une partie de ladite lumière d'excitation absorbée en une lumière d'émission ayant une longueur d'onde différente de celle de la lumière d'excitation. On pourra prévoir indifféremment que les moyens de conversion de longueur d'onde sont noyés dans la masse du matériau polymère, ou bien qu'ils sont disposés en surface de la couche de ce matériau polymère.

La source de lumière peut comporter en outre un revêtement de matériau réfléchissant la lumière qui est disposé entre les bâtonnets électroluminescents 8 pour dévier les rayons, initialement orientés vers le substrat, vers la face terminale 26 des bâtonnets électroluminescents 8. En d'autres termes, la face supérieure 16 du substrat 10 peut comporter un moyen réfléchissant qui renvoie les rayons lumineux, initialement orientés vers la face supérieure 16, vers la face de sortie de la source de lumière. On récupère ainsi des rayons qui autrement seraient perdus. Ce revêtement est disposé entre les bâtonnets électroluminescents 8 sur la couche d'oxyde conducteur transparent 29.

Les bâtonnets électroluminescents 8 sont agencés en matrice à deux dimensions. Cet agencement pourrait être tel que les bâtonnets soient agencés en quinconce. De manière générale, les bâtonnets sont disposés à intervalles réguliers sur le substrat 10 et la distance de séparation de deux bâtonnets électroluminescents immédiatement adjacents, dans chacune des dimensions de la matrice, doit être au minimum égale à 2 micromètres, afin que la lumière émise par la paroi circonférentielle 28 de chaque bâtonnet 8 puisse sortir de la matrice de bâtonnets électroluminescents. Par ailleurs, on prévoit que ces distances de séparation, mesurées entre deux axes d'allongement 22 de bâtonnets adjacents, ne soient pas supérieures à 100 micromètres.

Les bâtonnets électroluminescents 8 de dimensions submillimétriques définissent dans un plan, sensiblement parallèle au substrat 10, une surface d'émission 30 déterminée. On comprend que la forme de cette surface d'émission est définie en fonction du nombre et de l'agencement des éléments émissifs qui la composent. Dans ce qui suit, on définit une forme sensiblement rectangulaire de la surface d'émission, étant entendu que celle-ci peut varier et prendre n'importe quelle forme sans sortir du contexte de l'invention.

Notamment, la surface d'émission 30 peut prendre une forme carrée, telle qu'illustrée sur les figures. A titre d'exemple non limitatif, la surface d'émission peut présenter un côté de longueur égale à 2.66mm.

La source de lumière 1 est disposée sur le foyer F de l'optique de mise en forme, de manière à ce que les rayons émis par la source de lumière ressortent en sortie du projecteur sensiblement parallèlement à l'axe optique X. A titre d'exemple non limitatif, la source de lumière pourra être disposée à 30mm de celle-ci.

Selon l'invention, et ce quelle que soit la forme de la surface d'émission 30, celle-ci comporte au moins trois portions activables sélectivement, parmi lesquelles une première portion 31, une deuxième portion 32 et une troisième portion 33. Ces trois portions sont connectées électriquement sélectivement l'une de l'autre pour former des zones d'allumage distinctes et avantageusement complémentaires. Un module de commande 34, représenté sur la figure 1, associé à la source de lumière 1 est configuré pour piloter l'activation d'au moins une portion indépendamment de l'activation des autres portions, ou bien pour piloter simultanément l'ensemble des portions.

Tel que cela a pu être détaillé précédemment, la source de lumière 1 à semi-conducteur comprenant des bâtonnets électroluminescents qui va être décrit ci-après s'inscrit dans le cadre d'une utilisation d'un dispositif lumineux comportant par ailleurs une optique de mise en forme 6 apte à imager à l'infini au moins une partie des rayons lumineux émis par les différentes portions de bâtonnets de la source de lumière, en vue de générer au moins deux fonctions d'éclairage et/ou de signalisation, à savoir au moins une fonction de type « feux de route » et une fonction de type « feux de croisement ».

On va maintenant décrire un premier mode de mise en oeuvre de la source de lumière 1 dans lequel les éléments émissifs 8 sont agencés pour que la surface d'émission 30 comporte trois portions activables sélectivement à l'intérieur de laquelle chaque élément émissif est semblable.

Tel que cela a pu être précisé auparavant, un tel mode de mise en oeuvre s'applique sur tout type de source monolithique, aussi bien avec des bâtonnets électroluminescents s'étendant respectivement en saillie d'un même substrat, tels que décrit ci-dessus, qu'avec des blocs émissifs obtenus par découpage de couches électroluminescentes superposées sur un même substrat.

La première portion 31 et la deuxième portion 32 sont agencées symétriquement l'une de l'autre par rapport à un plan de symétrie P1, et la troisième portion 33 s'étend en chevauchement de ce plan de symétrie sur une partie seulement de l'étendue de la surface d'émission le long de ce plan de symétrie, en étant également répartie de chaque côté du plan de symétrie. La première et la deuxième portion comportent un bord commun, qui définit une zone de contact 35 entre ces portions. La zone de contact 35 est confondue avec la droite formée à la jonction du plan de symétrie P1 et du plan dans lequel s'inscrit la surface d'émission. La troisième portion 33 présente une extrémité interne 331 agencée à l'intérieur de la source de lumière et une extrémité externe 332 débouchant sur un bord de la source de lumière. La troisième portion présente la forme d'une bande, dont l'extrémité interne 331 s'étend en une pointe centrée sur le plan de symétrie, et qui forme dans la surface d'émission un angle α (visible sur les figures 4 à 7) avec le plan de symétrie qui est égal à 35°, étant entendu que des variations sont envisageables, par exemple de l'ordre de 5°. On pourrait en variante prévoir une forme différente de la pointe, avec par exemple une pointe dont l'inclinaison est comprise entre 15° et 90°, avantageusement entre 15° et 45°. On comprend que la variation de la pente permet de générer dans le faisceau projeté du type « feux de croisement » une marche plus ou moins abrupte de la coupure du faisceau.

Il résulte de cet agencement que le sommet de la pointe formée à l'extrémité interne 331 de la troisième portion 33 est confondu avec le point d'intersection 36 des première 31, deuxième 32 et troisième 33 portions activables sélectivement.

La première portion 31 présente un bord interne commun successivement avec les deux autres portions et trois bords externes qui délimitent le contour périphérique de la surface d'émission. Symétriquement, la deuxième portion participe à délimiter la surface d'émission. Et tel que cela a été précisé précédemment, la troisième portion présente une extrémité externe 332 débouchant sur un bord de la source de lumière. Il en résulte que chacun des côtés de la source de la lumière est formé par un bord d'au moins une des portions activables sélectivement et que chacune des portions activables sélectivement débouche sur au moins un bord de la surface d'émission de la source de lumière. Ceci est particulièrement intéressant pour le raccordement électrique de l'ensemble des éléments émissifs de la source de lumière. Les branchements respectifs de chaque portion activable sélectivement peuvent ainsi être effectués depuis un bord de la source de lumière 1, pour être raccordés à l'extérieur de la source de lumière sur une source d'alimentation électrique ici non représentée. L'ensemble des éléments émissifs d'une portion activable sélectivement est raccordé ensemble, notamment par une conformation de l'électrode ménagée sur la face inférieure du substrat, de sorte que l'alimentation électrique d'un des éléments émissifs assure l'alimentation électrique de l'ensemble de la portion correspondante.

Selon l'invention, la source de lumière est agencée de manière à former trois portions activables sélectivement, et une séparation de deux portions voisines peut être obtenue par la réalisation physique d'un muret s'étendant en saillie du substrat 10, étant entendu qu'elle peut être uniquement réalisée par le câblage déterminé des éléments émissifs 8 entre eux.

Les trois portions activables sélectivement présentent chacune une forme telle que la troisième portion s'étend depuis un bord latéral 38 de la source de lumière qui selon un premier cas d'application, à savoir une conduite à gauche de la route, est agencé à droite de la source de lumière lorsque celle-ci est en position d'émission dans le module lumineux, et qui selon un deuxième cas d'application, à savoir une conduite à droite de la route, est agencé à gauche de la source de lumière lorsque celle-ci est en position d'émission dans le module lumineux.

On comprend que l'agencement du bord latéral 38 et de la troisième portion 33 en conséquence est ici défini en vue de face de la source de lumière. Si l'on prend l'exemple des figures 3 à 5, sur lesquelles le bord latéral 38 est à droite de la source lorsque l'on regarde cette source de face, il en résulte que la partie du faisceau correspondant aux rayons émis par cette troisième portion, disposée à droite de la source vue de face et donc à gauche de l'axe optique vue depuis le conducteur, est une partie droite du faisceau, les rayons étant projetés en imagerie directe, directement depuis la source sur l'optique de mise en forme.

Selon l'invention, il est avantageux que la même source de lumière puisse être utilisée dans l'un ou l'autre des cas d'application, avec uniquement une rotation autour d'un axe O1 perpendiculaire à la surface d'émission et passant par le centre de la surface d'émission. Tel que cela peut être observé sur la figure 3, l'axe O1 peut passer par le centre de la source de lumière, et former dans le plan de la surface d'émission un point distinct du point d'intersection 36 des différentes portions activables sélectivement.

On saura décrire ci-après chacun des cas d'application et la mise en oeuvre du pivotement de la source de lumière d'un cas à l'autre. A cet effet, la source de lumière peut comporter des moyens de détrompage 39 de son installation dans le module lumineux.

Les moyens de détrompage peuvent consister en un repère de forme ou de couleur spécifique ménagé en bordure de la surface d'émission. A titre d'exemple non limitatif, on a illustré sur les figures 3 à 7 un repère porté par une patte d'extension 40 de la source de lumière agencée sur un bord définissant le contour de la source de lumière. Cette patte d'extension pourra être formée par un prolongement du substrat. Le repère réalisé sur cette patte d'extension est identifiable par un dispositif de contrôle lors de la mise en place de la source de lumière dans le module lumineux. A titre d'exemple, le dispositif de contrôle pourra consister en des moyens d'indexation mécanique, susceptible de détecter par coopération de forme si le repère est à la place souhaitée, ou bien en des moyens d'acquisition d'image. On pourra également prévoir que le repère est un point de couleur réalisé dans la surface d'émission entre des éléments émissifs et le dispositif de contrôle peut alors consister en des moyens d'acquisition d'image susceptible de valider la présence du point de couleur dans la zone voulue. On comprend que cette zone doit être décentrée par rapport au centre de la surface d'émission afin d'être spécifique à la position de la source de lumière dans chacun des cas d'application.

Dans chacune des portions activables sélectivement sont disposés plusieurs bâtonnets électroluminescents de dimensions submillimétriques, les bâtonnets associés respectivement à chacune de ces deux portions étant connectés électriquement pour que les zones soient activables sélectivement, de part et d'autre de la séparation. On a représenté sur la figure 3 la distance de séparation d3 entre un bâtonnet d'une première portion 31 et un bâtonnet directement adjacent et appartenant à la deuxième portion 32 ou à la troisième portion 33. On convient que cette distance de séparation d3, mesurée entre deux axes longitudinaux de bâtonnets électroluminescents, doit être au minimum égale à 2 micromètres, afin que la lumière émise par la paroi circonférentielle 28 de chaque bâtonnet 8 puisse sortir de la matrice de bâtonnets électroluminescents, et on cherche à avoir une distance de séparation d3 entre deux bâtonnets de deux sources différentes qui est sensiblement égale à la distance de séparation dl ou d2 de deux bâtonnets d'une même portion de la source de lumière.

Il convient de noter que dans la variante de source monolithique telle qu'elle a été évoquée précédemment, à savoir un découpage de blocs émissifs disposés en saillie d'un substrat unique, chaque bloc formant une portion activable sélectivement et de la sorte un pixel, on aura également à considérer une distance de séparation entre deux pixels. Cette distance sera notamment inférieure à 500 micromètres, et elle sera préférentiellement inférieure à 200 micromètres.

Tel que cela a été précisé précédemment, le substrat est commun à l'ensemble des bâtonnets composant les différentes portions de la source de lumière à semi-conducteur. On optimise ainsi le nombre de fils de raccordement électriques, et on facilite le rapprochement l'une de l'autre des portions de la source de lumière, le caractère jointif de cet agencement étant particulièrement intéressant pour l'obtention d'un flux homogène lorsque les deux portions de la source de lumière à semi-conducteur sont activées simultanément.

On va maintenant décrire le procédé de mise en oeuvre d'une source de lumière telle que décrite précédemment, afin de réaliser les deux fonctions d'éclairage que sont la fonction d'éclairage non éblouissant, par l'intermédiaire d'un faisceau à coupure, et la fonction d'éclairage longue portée.

On se réfère tout d'abord aux figures 4 et 5, qui illustrent une implantation de la source de lumière selon l'invention dans un véhicule spécifique à la conduite à gauche, avec sur la figure 4 la configuration de la source pour la réalisation de la fonction d'éclairage non éblouissant et sur la figure 5 la configuration de la source pour la réalisation de la fonction d'éclairage à longue portée.

On comprend que le module lumineux dans lequel est incorporée cette source fonctionne en imagerie directe, c'est-à-dire que l'image projetée sur la scène de route est inversée par rapport à la disposition des éléments émissifs dans la surface d'émission de la source de lumière. De la sorte, lorsque la source de lumière est en position d'émission au foyer F de l'optique de mise en forme 6, la portion du faisceau correspondant à la partie haute, respectivement basse de la source, est projetée sur la scène de route au loin, respectivement au près, du véhicule. Par ailleurs, et tel que cela a pu être évoqué ci-dessus, la portion du faisceau correspondant à la partie droite de la source lorsqu'on la regarde de face, c'est-à-dire notamment la troisième portion 33 sur les figures 3 à 5, est projetée sur la scène de route sur la droite de celle-ci vue depuis le poste de pilotage par le conducteur.

Tel que cela a pu être précisé, les différentes portions de la surface d'émission 30 de la source de lumière sont activables sélectivement l'une de l'autre, et le faisceau projeté par l'optique associée lorsque c'est l'une de ces portions qui émet des rayons est complémentaire d'un faisceau projeté lorsque c'est une autre portion de la surface d'émission qui est activée. Ces faisceaux complémentaires se superposent pour former un faisceau lumineux réglementaire pour véhicule automobile.

On active l'intégralité des éléments émissifs composant la surface d'émission, donc chacune des trois portions de la source de lumière, pour réaliser la fonction d'éclairage à longue portée. Tel que cela est visible sur la figure 5, la première portion 31 est activée et elle émet des rayons lumineux (représentation hachurée), de même que la deuxième portion 32 et la troisième portion 33. Pour la réalisation de cette fonction d'éclairage à longue portée, les trois portions sont activées simultanément et l'alimentation électrique correspondante est dimensionnée de manière à produire le maximum d'intensité lumineuse permis par la dimension et la structure de chacune des portions.

Lorsque l'on souhaite réaliser la fonction d'éclairage non éblouissante, tel que cela est visible sur la figure 4, seule la première portion 31 est activée. La deuxième portion 32 et la troisième portion 33 n'émettent aucun rayon (représentation non hachurée), et cette deuxième portion est disposée vers le bas dans cet agencement, de sorte que la partie supérieure du faisceau projeté par l'optique de mise en forme est sombre et ne participe pas à l'éblouissement des autres usagers sur la scène de route. L'activation de la première portion 31 sans que soit activée la troisième portion 33 permet de former une marche dans le faisceau émis, c'est-à-dire avec une limite supérieure du faisceau projeté qui n'est pas rectiligne et parallèle à la ligne d'horizon.

Pour la réalisation de cette fonction d'éclairage à coupure, la première portion 31 est activée indépendamment de la deuxième portion 32 et de la troisième portion 33, et l'alimentation électrique correspondante nécessaire pour l'activation de cette première portion est dimensionnée de manière à produire une intensité lumineuse comprise entre 30 et 50% du maximum d'intensité lumineuse permis par la dimension et la structure de cette première portion.

On se réfère dans un deuxième temps aux figures 6 et 7, qui illustrent l'implantation de la même source de lumière précédemment décrite en référence aux figures 4 et 5 dans un module lumineux d'un véhicule spécifique à la conduite à droite. La source de lumière est à cette occasion pivotée de 180° autour d'un axe de rotation perpendiculaire au plan de la surface d'émission et passant par la zone de jonction entre la première portion et la deuxième portion. Conformément à ce qui a pu être décrit précédemment, on a illustré sur la figure 6 la configuration de la source pour la réalisation de la fonction d'éclairage non éblouissant et sur la figure 7 la configuration de la source pour la réalisation de la fonction d'éclairage à longue portée.

Le procédé de mise en oeuvre diffère en ce que, pour la réalisation de la fonction d'éclairage non éblouissant, c'est la deuxième portion 32 qui est activée, indépendamment de la première portion 31 et de la troisième portion 33 qui restent elles inactives, puisqu'après rotation à 180° de la source de lumière, c'est désormais la deuxième portion 32 qui est disposée au-dessus de la première portion 31 dans la position d'émission de la source de la lumière et que ce sont donc les rayons émis par la deuxième portion 32 qui correspondent à la partie basse du faisceau projeté en sortie de l'optique de mise en forme. On constate bien que dans ce cas, la troisième portion 33 est cette fois disposée à gauche de la source de lumière lorsque l'on regarde celle-ci de face, et donc que les rayons correspondant, formant la marche dans le faisceau à coupure, sont sur la gauche du faisceau projeté, de sorte que la coupure du faisceau qui résulte d'un allumage uniquement de la deuxième portion, à l'exception de la troisième portion, est spécifique d'un véhicule dédié à la conduite à droite de la route.

Par ailleurs, conformément à ce qui a pu être précédemment décrit, l'ensemble des portions est activé lorsque l'on souhaite réaliser une fonction d'éclairage à longue portée.

Il résulte de ce qui précède que, selon l'invention, lorsqu'un faisceau à coupure doit être émis, le module de commande 34 génère des instructions d'allumage de l'une ou l'autre des première et deuxième portions, le choix de l'activation de la première portion ou de la deuxième portion étant fonction de l'orientation de la source de lumière.

Le procédé d'éclairage selon l'invention comporte ainsi une étape de récupération d'informations relative à l'orientation de la source de lumière, par exemple par l'intermédiaire des systèmes d'acquisition d'images préalablement décrits.

On va maintenant décrire une première variante de réalisation, illustrée sur la figure 8, et qui diffère des cas précédemment présentés en ce que les première et deuxième portions 31, 32 de la surface d'émission 30 comportent des ensembles d'éléments émissifs pilotés distinctement les uns des autres au sein de la même portion et formant des sous-ensembles d'éclairage 41.

Chacune des première et deuxième portions comporte un sous-ensemble 41 agencé le long de la troisième portion 33 et le long de la zone de contact 35 entre ces deux portions, depuis le point d'intersection 36. On a illustré sur la figure 8 chaque sous-ensemble par un trait en pointillés. Dans l'exemple illustré, chaque sous-ensemble 41 s'étend sur tout le long de la zone de contact entre la première portion et la deuxième portion, mais on pourra sans sortir du contexte de l'invention prévoir que les sous-ensembles ne s'étendent pas d'un bord latéral de la source de lumière à l'autre et que dans ce cas, ils s'étendent sur toute la zone de contact avec la troisième portion et partiellement le long de la zone de contact entre la première portion et la deuxième portion.

La largeur de chaque sous-ensemble est avantageusement constante sur toute son étendue, et par exemple d'un bord à l'autre de la surface d'émission de la source.

Lorsque l'ensemble des portions activables sélectivement est activé pour réaliser une fonction d'éclairage à longue portée, les éléments émissifs sont alimentés de sorte qu'ils émettent à 100% de leurs capacités, de sorte qu'on ne peut identifier l'émission lumineuse réalisée par les éléments émissifs correspondant aux sous-ensembles de chacune des première et deuxième portions.

Par contre, lorsque seule la première 31 ou la deuxième portion 32 est activée pour réaliser une fonction d'éclairage non éblouissante, les rayons émis par les éléments émissifs correspondant au sous-ensemble de cette première ou deuxième portion sont des rayons formant la partie du faisceau la plus proche de la coupure. Ce sous-ensemble 41 est alors piloté de manière à produire une surintensité lumineuse par rapport au reste du faisceau produit par les rayons émis par la première ou la deuxième portion, afin de proposer un contraste net au niveau du bord de coupure du faisceau et améliorer le compromis entre le non-éblouissement recherché des autres usagers de la route et l'efficacité de l'éclairage au voisinage direct des véhicules de ces autres usagers.

Le sous-ensemble 41 de l'une parmi la première portion 31 ou la deuxième portion 32 est activée pour la réalisation de la première fonction d'éclairage de manière à produire une intensité lumineuse sensiblement égale à 50% du maximum d'intensité lumineuse permis par la dimension et la structure des éléments émissifs le composant, tandis que le reste de la première ou de la deuxième portion correspondante est activée pour la réalisation de la première fonction d'éclairage de manière à produire une intensité lumineuse sensiblement égale à 30% du maximum d'intensité lumineuse permis par la dimension et la structure des éléments émissifs la composant, les éléments émissifs étant identique entre le sous-ensemble et le reste de la première ou deuxième portion.

Dans ce contexte, la densité et/ou la hauteur des bâtonnets 8 peut être différente dans une même portion entre ceux disposés dans le sous-ensemble et les autres. On modifie ainsi l'étendue des partie émissives dans la surface d'émission, en augmentant la hauteur de la paroi circonférentielle 28 ou en multipliant le nombre de bâtonnets et de ces parois circonférentielles, et on augmente de la sorte l'intensité lumineuse émissible par une partie de la portion par rapport au reste.

Alternativement ou cumulativement, on pourra prévoir que les éléments émissifs agencés dans le sous-ensemble sont suralimentés par rapport au reste des éléments émissifs de la portion correspondante.

Une deuxième variante de réalisation est illustrée sur la figure 9, dans laquelle la source de lumière 1 telle qu'elle a été décrite précédemment comporte en outre une partie périphérique 101 formée de deux portions additionnelles 102, 103 et qui vient entourer les première 31, deuxième 32 et troisième 33 portions activables sélectivement de la source de lumière. Ces deux portions additionnelles sont agencées symétriquement de part et d'autre du plan de symétrie P1 de la source de lumière. On comprend que selon l'implantation de la source de lumière dans un projecteur pour un véhicule destiné pour une conduite à gauche ou pour un véhicule destiné pour une conduite à droite, ces portions additionnelles sont indifférentes et peuvent être laissées en position alors que l'on fait pivoter les première, deuxième et troisième portions de la source de lumière.

Dans le cas où l'on souhaite réaliser un faisceau d'éclairage de type « feux de croisement », seule la partie supérieure de la source de lumière est activée, c'est-à-dire la première portion dans le cas d'une conduite à gauche et la deuxième portion dans le cas d'une conduite à droite, et donc seule la première portion additionnelle 101 entourant plus spécifiquement la partie supérieure de la source de lumière est activée.

Dans le cas où l'on souhaite réaliser un faisceau d'éclairage de type « feux de route », avec l'ensemble des portions de la source de lumière qui est activé, on comprend que la première portion additionnelle 101 et la deuxième portion additionnelle 102 sont activées.

La présente invention s'applique tout particulièrement à un projecteur avant de véhicule automobile. Un tel projecteur peut comporter un module lumineux tel qu'il a été illustré sur la figure 1 et décrit dans ce qui précède, et il pourra comporter un module lumineux complémentaire configuré pour former un faisceau complémentaire au faisceau formé en sortie du module lumineux.

La description qui précède explique clairement comment l'invention permet d'atteindre les objectifs qu'elle s'est fixés et notamment de proposer un dispositif lumineux qui permette de réaliser à moindre coût, et sans perte de qualité photométrique, un éclairage bi-fonction, c'est-à-dire un éclairage qui permette la réalisation d'une fonction d'éclairage non éblouissant, à coupure, et une fonction d'éclairage à longue portée, avec une unique optique de mise en forme. Il est particulièrement avantageux selon l'invention que l'on combine une source monolithique, et par exemple une source à semi-conducteur comprenant des bâtonnets électroluminescents, et une optique de mise en forme simple, c'est-à-dire à titre d'exemple une lentille convergente et/ou un miroir parabolique, sans que soit nécessaire des surfaces optiques intermédiaires entre ces deux éléments.

L'utilisation d'une source monolithique est particulièrement avantageuse en ce qu'elle permet la mise en place de plusieurs portions dans la zone émettrice avec des découpages obliques entre les portions séparées les unes des autres, et en ce qu'elle permet dans ce contexte d'avoir une homogénéité de l'émission de lumière dans l'ensemble de chacune des portions et notamment dans les pointes formées par les découpage obliques. On comprend que ceci ne peut pas être obtenu avec des sources LED classiques, avec une chip bleue carrée soudée sur une plaque de circuits imprimés et recouverte de luminophore.

Bien entendu, diverses modifications peuvent être apportées par l'homme du métier à la structure du dispositif lumineux qui vient d'être décrite à titre d'exemple non limitatif, dès lors qu'elle utilise au moins une source de lumière comprenant des portions d'éléments émissifs qui sont activables sélectivement et qui sont pilotées pour pouvoir générer un faisceau à coupure d'un premier type, c'est-à-dire pour une conduite à gauche, lorsque la source de lumière est dans une première position, et un faisceau à coupure d'un deuxième type, c'est-à-dire pour une conduite à droite, lorsque la source de lumière est dans une deuxième position. En tout état de cause, l'invention ne saurait se limiter au mode de réalisation spécifiquement décrit dans ce document, et s'étend en particulier à tous moyens équivalents et à toute combinaison techniquement opérante de ces moyens.

## Revendications

1. Source de lumière monolithique (1) pour un module lumineux de véhicule automobile comprenant une surface d'émission (30) formée par une pluralité de bâtonnets électroluminescents (8), de dimension submillimétrique, et configurée de sorte que les éléments émissifs sont agencés en au moins trois portions activables sélectivement parmi lesquelles une première (31) et une deuxième (32) portions qui sont symétriques l'une de l'autre par rapport à un plan de symétrie (P1), avec une zone de contact (35) qui s'étend le long de ce plan de symétrie, et une troisième portion (33) qui s'étend depuis une extrémité de cette zone de contact et qui s'étend symétriquement de part et d'autre du plan de symétrie.

2. Source de lumière monolithique selon la revendication précédente, **caractérisé en ce que** la troisième portion (33) présente une forme de bande dont l'épaisseur à une extrémité interne (331) diminue progressivement pour former une pointe dont le sommet est confondu avec le point d'intersection (36) des première (31), deuxième (32) et troisième (33) portions activables sélectivement.

3. Source de lumière monolithique selon la revendication précédente, **caractérisé en ce que** la pointe participant à délimiter la troisième portion (33) forme dans la surface d'émission (30) un angle avec le plan de symétrie qui est compris entre 15° et 90°.

4. Source de lumière monolithique selon la revendication précédente, **caractérisé en ce que** la pointe participant à délimiter la troisième portion (33) forme dans la surface d'émission (30) un angle avec le plan de symétrie qui est égal à 35° +/- 5°.

5. Source de lumière monolithique selon l'une des revendications précédentes, **caractérisé en ce que** la surface d'émission (30) est rectangulaire.

6. Source de lumière monolithique selon la revendication précédente, **caractérisé en ce que** chacune des portions d'émission (31, 32, 33) débouche sur un bord de la surface d'émission (30).

7. Source de lumière monolithique selon l'une des revendications précédentes, en combinaison avec la revendication 2, **caractérisé en ce que** chacune des première (31) et deuxième (32) portions comporte un sous-ensemble (41) agencé le long de la troisième portion (33) et au moins partiellement le long de la zone de contact (35) entre ces deux portions, depuis le point d'intersection (36).

8. Source de lumière monolithique selon la revendication précédente, **caractérisé en ce que** chaque sous-ensemble (41) s'étend sur tout le long de la zone de contact (35) entre la première portion (31) et la deuxième portion (32).

9. Source de lumière monolithique selon la revendication précédente, **caractérisé en ce que** la largeur de chaque sous-ensemble (41) est constante d'un bord à l'autre de la surface d'émission de la source de lumière (1).

10. Source de lumière monolithique selon l'une des revendications précédentes, **caractérisé en ce que** les éléments émissifs (8) contenus dans un sous-ensemble (41) sont configurés pour émettre des rayons d'intensité lumineuse supérieure à celle des rayons émis par les éléments émissifs contenus dans le reste de la première (31) ou deuxième (32) portion que comporte ledit sous-ensemble.

11. Source de lumière monolithique selon l'une des revendications précédentes, **caractérisé en ce qu'**elle comporte des moyens de détrompage (39, 40) de son installation dans le module lumineux.

12. Module lumineux comportant une source de lumière monolithique (1) selon l'une des revendications précédentes et une optique de mise en forme (6).

13. Module selon la revendication précédente, **caractérisé en ce que** la source de lumière monolithique (1) et l'optique de mise en forme (6) sont configurées de sorte que les rayons émis par la source de lumière monolithique impactent directement l'optique de mise en forme, sans déviation intermédiaire.

14. Module selon la revendication précédente, **caractérisé en ce que** l'optique de mise en forme (6) est configurée pour déformer l'image selon au moins un axe.

15. Projecteur de véhicule automobile comportant un module lumineux selon l'une des revendications 12 à 14.

16. Procédé d'éclairage d'un véhicule automobile mettant en oeuvre le pilotage d'une source de lumière monolithique selon l'une des revendications 1 à 11 pour réaliser une première fonction d'éclairage non éblouissante, par projection d'un faisceau à coupure, ou une deuxième fonction d'éclairage à longue portée, par projection d'un deuxième faisceau sans coupure, au cours duquel on détecte l'orientation de la source de lumière monolithique (1) et au cours duquel on active chacune des trois portions (31, 32, 33) de la source de lumière pour réaliser la deuxième fonction d'éclairage à longue portée, et uniquement l'une parmi la première portion (31) et la deuxième portion (32) pour réaliser la première fonction d'éclairage non éblouissante, le choix de l'activation de la première ou de la deuxième portion étant fonction de la détection de l'orientation de la source de lumière.
